# EUROPEAN PATENT APPLICATION

(11) **EP 4 583 532 A1**
(43) Date of publication of application: **09.07.2025**
(21) Application number: 23937293.1
(22) Date of filing: 05.12.2023
(51) Int. Cl.: H04R 1/10

(54) **ACOUSTIC OUTPUT DEVICE**

(30) Priority: 12.05.2023 CN 202310541798
(71) Applicant: Shenzhen Shokz Co., Ltd., Shenzhen, Guangdong 518108 (CN)
(72) Inventor: ZHU, Guangyuan, Shenzhen, Guangdong 518108 (CN); ZHANG, Lei, Shenzhen, Guangdong 518108 (CN); QI, Xin, Shenzhen, Guangdong 518108 (CN)
(74) Representative: Wang, Bo
(86) International application number: PCT/CN2023/136558
(87) International publication number: WO 2024/234622

(57) **Abstract**

An acoustic output device (100) includes a housing (10); a bone conduction vibrator (11) configured to generate bone conduction sound waves and transmit the bone conduction sound waves to a cochlea through the housing (10) to produce sound; an air conduction vibrator (12) configured to generate air conduction sound waves, the air conduction sound waves being transmitted to an ear through sound guiding holes in the housing (10); and a processing module configured to provide the bone conduction vibrator (11) and the air conduction vibrator (12) with a first audio signal and a second audio signal, respectively, the first audio signal and the second audio signal having a frequency division point, the first audio signal and the second audio signal including components with frequencies above and below the frequency division point, respectively. The frequency division point is not less than 600 Hz. This acoustic output device can effectively reduce the overall power consumption, while achieving sufficient volume output and low sound leakage performance.

## Description

### CROSS-REFERENCE TO RELATED APPLICATION

This application claims priority of Chinese Patent Application No. 202310541798. X, filed on May 12, 2023, the contents of which are entirely incorporated herein by reference.

### TECHNICAL FIELD

The present disclosure relates to the acoustic field, and in particular to an acoustic output device.

### BACKGROUND

The power consumption, volume, and sound leakage of acoustic output devices affect and constrain each other. When a greater volume is output, the power consumption of the acoustic output device is greater, and a sound leakage performance is not ideal.

Therefore, it is necessary to propose an acoustic output device that effectively reduces the power consumption of the whole device while realizing a sufficient volume output and a low sound leakage.

### SUMMARY

One of the embodiments of the present disclosure provides an acoustic output device including a housing; a bone conduction vibrator configured to generate bone conduction sound waves and transmit the bone conduction sound waves to a cochlea through the housing to produce sound; an air conduction vibrator configured to generate air conduction sound waves, the air conduction sound waves being transmitted to an ear through sound guiding holes in the housing; and a processing module configured to provide the bone conduction vibrator and the air conduction vibrator with a first audio signal and a second audio signal, respectively. The first audio signal and the second audio signal have a frequency division point. The first audio signal and the second audio signal include components with frequencies above and below the frequency division point, respectively. The frequency division point is not less than 600 Hz.

In some embodiments, the frequency division point is not less than 1500 Hz.

In some embodiments, the housing includes two sound guiding holes. Sounds radiated through the two sound guiding holes to a far-field show a directivity, the directivity being expressed as a difference between a sound pressure level in a direction of a line connecting the two sound guiding holes and a sound pressure level in at least one other direction being not less than 3 dB.

In some embodiments, an amplitude difference between sounds emitted from the two sound guiding holes is less than 6 dB and a phase difference between the sounds emitted from the two sound guiding holes is 150°-210°.

In some embodiments, a difference between sound loads of the two sound guiding holes is less than 0.15.

In some embodiments, a ratio of surface sound loads of the two sound guiding holes is 0.5-3.5.

In some embodiments, the frequency division point is not higher than 4000 Hz.

In some embodiments, the processing module obtains the first audio signal and the second audio signal by performing a high-pass filtering process and a low-pass filtering process on an electrical signal containing sound information.

In some embodiments, the bone conduction vibrator includes a first magnetic circuit, a vibration sheet, and a first coil, and the air conduction vibrator includes a diaphragm, a second magnetic circuit, and a second coil, an angle between a first vibration direction of the vibration sheet in the first magnetic circuit and a second vibration direction of the diaphragm in the second magnetic circuit being in a range of 80°-100°.

In some embodiments, a mass center of the bone conduction vibrator is spaced apart from a mass center of the air conduction vibrator in a first vibration direction.

In some embodiments, the mass center of the bone conduction vibrator is flush with the mass center of the air conduction vibrator in the second vibration direction, and the bone conduction vibrator rotates relative to the air conduction vibrator.

In some embodiments, the bone conduction vibrator includes two vibration sheets symmetrically disposed on both sides of the first magnetic circuit, and a symmetry axis of the two vibration sheets is spaced apart from a center axis of the air conduction vibrator in the first vibration direction.

In some embodiments, the second magnetic circuit of the air conduction vibrator is located on a side of the diaphragm away from the bone conduction vibrator.

In some embodiments, the housing includes a first sound guiding hole and a second sound guiding hole. The first sound guiding hole is located in a sidewall of the housing opposite to a bottom wall of the second magnetic circuit away from the diaphragm, and the second sound guiding hole is connected to a front cavity where a side of the diaphragm away from the second magnetic circuit is located.

In some embodiments, the acoustic output device further includes an earhook assembly connected to the housing, and the second sound guiding hole is disposed in a sidewall of the housing away from the earhook assembly in an extension direction of the earhook assembly.

In some embodiments, the second sound guiding hole includes two or more second sub-sound guiding holes, and the acoustic output device further includes the earhook assembly connected to the housing, and at least one of the two or more second sub-sound guiding holes is disposed on an outer sidewall of the housing.

In some embodiments, the vibration sheet includes a long axis direction perpendicular to the first vibration direction, and in the long axis direction, a distance between the lowest point of the bone conduction vibrator and the lowest point of an opening of the second sound guiding hole facing the outside of the acoustic output device is not less than 1.0 mm.

In some embodiments, a curvature radius of a corner formed by a first sidewall of the bone conduction vibrator close to the second sound guiding hole and a second sidewall of the bone conduction vibrator close to the diaphragm is greater than 1.0 mm.

In some embodiments, a distance from the center point of the corner formed by the first sidewall of the bone conduction vibrator near the second sound guiding hole and the second sidewall of the bone conduction vibrator near the diaphragm to the apex of the folded ring of the diaphragm is not less than 1.5 mm.

In some embodiments, the front cavity includes an airflow channel connected to the second sound guiding hole, and a minimum cross-sectional area of the airflow channel is not less than 5.3 mm².

In some embodiments, the acoustic output device further includes: a microphone. The housing is disposed with a microphone hole corresponding to the microphone, and the microphone hole and the second sound guiding hole are covered by a same steel mesh.

In some embodiments, the microphone hole is closer to the earhook assembly relative to the second sound guiding hole in a wearing state.

### BRIEF DESCRIPTION OF THE DRAWINGS

The present disclosure will be further illustrated by way of exemplary embodiments, which are described in detail by means of the accompanying drawings. These embodiments are not limiting, and in these embodiments, the same numbering denotes the same structure, wherein:
FIG. 1 is a schematic diagram illustrating an acoustic output device according to some embodiments of the present disclosure;
FIG. 2 is a schematic diagram illustrating a structure of a connection portion between a core assembly and an earhook assembly according to some embodiments of the present disclosure;
FIG. 3 is an exploded schematic diagram illustrating a structure of the core assembly in FIG. 2;
FIG. 4 is a schematic diagram illustrating a cross-section along a direction of an A-A section of a core assembly according to some embodiments of the present disclosure;
FIG. 5A is a schematic diagram illustrating a cross-section along a direction of a section A-A of a core assembly according to some other embodiments of the present disclosure;
FIG. 5B is a schematic diagram illustrating a structure of a core assembly according to some other embodiments of the present disclosure;
FIG. 6 is a schematic diagram illustrating a cross-section along a direction of a section B-B of a core assembly according to some embodiments of the present disclosure;
FIG. 7 is a schematic diagram illustrating a cross-section of a second sound guiding hole according to some embodiments of the present disclosure;
FIG. 8 is a schematic diagram illustrating a position where a second sound guiding hole is disposed according to some embodiments of the present disclosure;
FIG. 9 is a schematic diagram illustrating a surface of a portion of a housing according to some embodiments of the present disclosure;
FIG. 10 is a schematic diagram illustrating a surface of a portion of a housing according to some embodiments of the present disclosure; and
FIG. 11 is a diagram illustrating an effect of a frequency division point on a power consumption of an acoustic output device according to some embodiments of the present disclosure.

### DETAILED DESCRIPTION

To more clearly illustrate the technical solutions of the embodiments of the present disclosure, the following description of the accompanying drawings that need to be used in the description of the embodiments will be briefly described. Obviously, the accompanying drawings in the following description are only some examples or embodiments of the present disclosure, and it is possible for those skilled in the art to apply the present disclosure to other similar scenarios based on the accompanying drawings without creative labor. Unless obviously obtained from the context or the context illustrates otherwise, the same numeral in the drawings refers to the same structure or operation.

It should be understood that as used herein, the terms "system", "device", "unit" and/or "module" as used herein is a way to distinguish between different components, elements, parts, sections, or assemblies at different levels. However, the words may be replaced by other expressions if other words accomplish the same purpose.

As used in the present disclosure and the appended claims, the singular forms "a," "an," and "the" include plural referents unless the content clearly dictates otherwise. In general, the terms "including" and "comprising" suggest only the inclusion of clearly identified operations and elements, which do not constitute an exclusive list, and the method or device may also include other operations or elements.

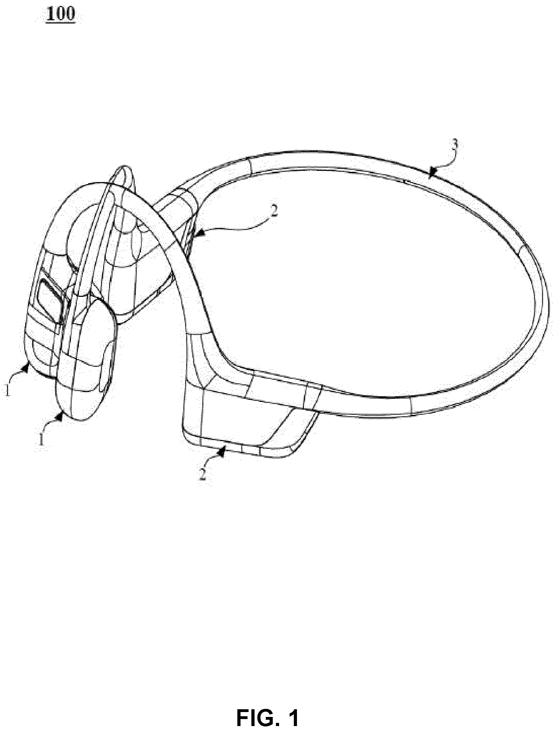

FIG. 1 is a schematic diagram illustrating an acoustic output device according to some embodiments of the present disclosure.

Some embodiments of the present disclosure provide an acoustic output device 100. As shown in FIG. 1, the acoustic output device 100 includes a core assembly 1, an earhook assembly 2, and a rear-hanging assembly 3. In some embodiments, there are two core assemblies 1. The two core assemblies 1 are used to transmit vibration and/or sound to the left and right ears of a user, respectively, and the two core assemblies 1 may be the same or different. For example, one core assembly 1 is provided with a microphone, and the other core assembly 1 is not provided with the microphone. As another example, one core assembly 1 is disposed with a key and a corresponding circuit board, and the other core assembly 1 is not provided with the key and the corresponding circuit board. The two core assemblies 1 may be the same on a core module (e.g., a speaker module). One of the two core assemblies 1 is described in detail later in the present disclosure as an example. There may be two earhook assemblies 2, and the two earhook assemblies 2 are hanging on the left and right ears of the user, respectively, so as to enable the core assembly 1 to fit the face of the user. Exemplarily, one earhook assembly 2 is disposed with a battery, and the other earhook assembly 2 is disposed with a control circuit, etc. One end of the earhook assembly 2 is connected to the core assembly 1, and the other end of the earhook assembly 2 is connected to the rear-hanging assembly 3. The rear-hanging assembly 3 connects the two earhook assemblies 2, and the rear-hanging assembly 3 is used to wrap around a back of a neck or a back of a head of the user, and is capable of providing a clamping force to allow the two core assemblies 1 to be clamped to two sides of the face of the user and to enable the earhook assembly 2 to be more securely attached to the ears of the user.

It is to be known that, in some embodiments, the acoustic output device 100 does not include the rear-hanging assembly 3, at which point the acoustic output device 100 includes the core assembly 1 and the earhook assembly 2. One end of the earhook assembly 2 may be connected to the core assembly 1, and the other end extends along a junction of the ear and the head of the user. In some embodiments, the earhook assembly 2 may be a curved structure adapted to fit the ear of the user to allow the earhook assembly 2 to hang on an auricle of the user. For example, the earhook assembly 2 has a curved structure that adapts to the junction of the head and the ear of the user so that the earhook assembly 2 is suspended between the ear and the head of the user. In some embodiments, the earhook assembly 2 is a clamping structure adapted to fit the auricle of the user so that the earhook assembly 2 is clamped at the auricle of the user. Exemplarily, the earhook assembly 2 includes a hooked portion and a connection portion connected in sequence. The connection portion connects the hooked portion to the core assembly 1 to enable the acoustic output device 100 to be curved in a three-dimensional space when the acoustic output device 100 is in a non-wearing state (i.e., a natural state). In other words, in the three-dimensional space, the hooked portion, the connection portion, and the core assembly 1 are not coplanar. In this way, when the acoustic output device 100 is in a wearing state, the hooked portion is primarily used for hooking between a back side of the ear and the head of the user, and the core assembly 1 is primarily used for contacting a front side of the ear or the head of the user, thereby allowing the core assembly 1 and the hooked portion to cooperate to be clamped to the ear. Exemplarily, the connection portion extends from the head toward an outer side of the head, thereby cooperating with the hooked portion to provide a compressive force for the core assembly 1 against the front side of the ear. The core assembly 1 may be pressed against a skin of the user under the compression force so that the acoustic output device 100 does not block an outer ear canal of the ear when the acoustic output device 100 is in the wearing state.

In some other embodiments, the acoustic output device 100 does not include the earhook assembly 2 and the rear-hanging assembly 3, but includes other fixing structures (not shown). The core assembly 1 is fixed to the fixing structure to affix the core assembly 1 to the ear, the head, or other part of the user via the fixing structure, thereby transmitting the air conduction sound waves and/or bone conduction sound waves output by the core assembly 1 to the user. For example, the fixing structure is a head-mounted structure connecting left and right core assemblies 1 to form a head-mounted acoustic output device. As another example, the fixing structure is a holder for eyeglasses, and the core assembly is fixed to the eyeglass holder. As a further example, the fixing structure is also a structure such as a helmet, a mask, etc., which is not specifically limited herein.

Structures such as the core assembly 1 of the acoustic output device 100 are described below in connection with the accompanying drawings.

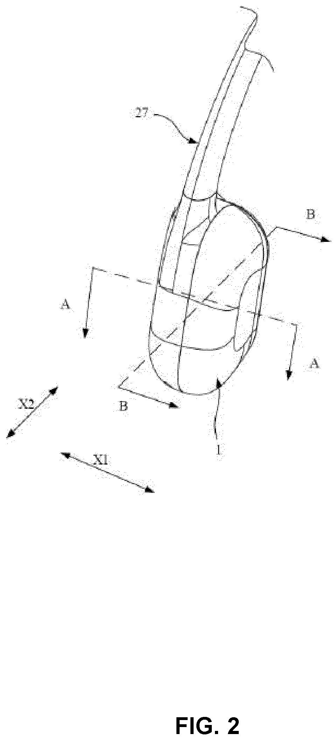

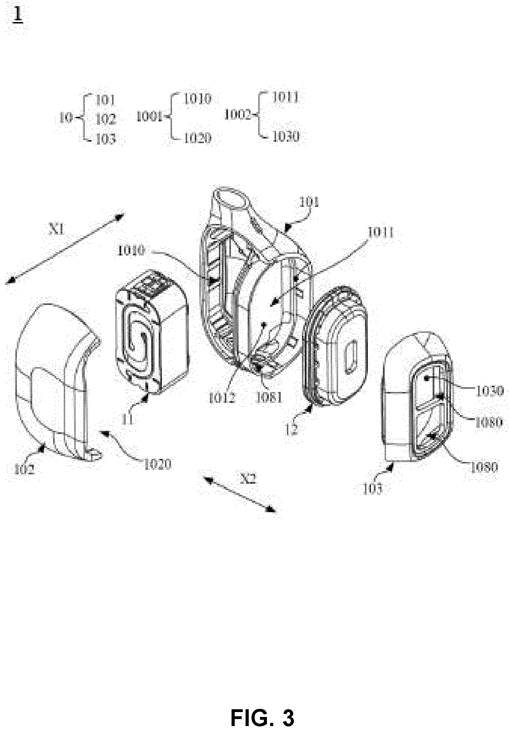

FIG. 2 is a schematic diagram illustrating a structure of a connection portion between a core assembly and the earhook assembly according to some embodiments of the present disclosure. FIG. 3 is an exploded schematic diagram illustrating a structure of the core assembly in FIG. 2. As shown in FIG. 2 and FIG. 3, the core assembly 1 includes a housing 10, a bone conduction vibrator 11, and an air conduction vibrator 12.

In some embodiments, the housing 10 is provided with an accommodation cavity 1001 and an accommodation cavity 1002 isolated from each other, and the accommodation cavity 1001 has a greater sealing than the accommodation cavity 1002. The bone conduction vibrator 11 is provided in the accommodation cavity 1001, and the air conduction vibrator 12 is provided in the accommodation cavity 1002. The acoustic output device 100 operates through the bone conduction vibrator 11 and the air conduction vibrator 12 together. The air conduction vibrator 12 is used to generate air conduction sound waves and transmit them through a sound guiding hole (e.g., the first sound guiding hole 1080) in the housing 10 to an ear (or an ear canal) of a user so that the user receives an air conduction sound, and the bone conduction vibrator 11 is used to generate bone conduction sound waves and transmit them through the housing 10 to a cochlea of the user to generate a bone conduction sound. In some embodiments, the accommodation cavity 1001 is set up as a completely sealed accommodation cavity, and the accommodation cavity 1002 is set up as an accommodation cavity with a high degree of sealing under a condition that a sound generated by the air conduction vibrator 12 is ensured. In this way, the bone conduction vibrator 11 and the air conduction vibrator 12 are provided independently from each other, which effectively improves a sealing effect of the bone conduction vibrator 11 so as to prevent the bone conduction vibrator 11 from being damaged by an erosion of external environmental factors, and at the same time ensure a sound quality effect of the air conduction vibrator 12. In addition, in the acoustic output device 100, when the bone conduction vibrator 11 and the air conduction vibrator 12 are working at the same time, the bone conduction vibrator 11 and the air conduction vibrator 12 are disposed in the accommodation cavity 1001 and the accommodation cavity 1002, respectively, which effectively prevents a mutual interference between the bone conduction vibrator 11 and the air conduction vibrator 12 (e.g., the mutual interference between the vibrations generated by the bone conduction vibrator 11 and the air conduction vibrator 12), thereby effectively improving the sound quality of the acoustic output device 100.

In some embodiments, referring to FIG. 2 and FIG. 3, the housing 10 includes a first housing 101, a second housing 102, and a third housing 103. The first housing 101 and the second housing 102 cooperate with each other to form the accommodation cavity 1001. The first housing 101 and/or the second housing 102 further form a portion of the accommodation cavity 1002. The third housing 103 and the first housing 101 and/or the second housing 102 cooperate to form another portion of the accommodation cavity 1002. In some embodiments, the housing 10 is formed by the first housing 101, the second housing 102, and the third housing 103 cooperating with each other. The first housing 101 and the second housing 102 cooperate to form the accommodation cavity 1001. The first housing 101 is disposed with a portion of the accommodation cavity 1002. The third housing 103 and the first housing 101 cooperate with each other to form another portion of the accommodation cavity 1002. The housing 10 is formed by the first housing 101, the second housing 102, and the third housing 103 cooperating with each other through the above structure, which makes the core assembly 1 compact and at the same time facilitates an assembling of the core assembly 1 to enhance an assembly efficiency of the core assembly 1. In some embodiments, a portion of the accommodation cavity 1002 is disposed in the second housing 102, and the third housing 103 and the second housing 102 cooperate with each other to form another portion of the accommodation cavity 1002. Alternatively, the first housing 101 and the second housing 102 cooperate to form a portion of the accommodation cavity 1002. The third housing 103, the first housing 101, and the second housing 102 cooperate with each other to form another portion of the accommodation cavity 1002. The housing 10 realized by any of the above embodiments may make the core assembly 1 compact while facilitating the assembling of the core assembly 1 to enhance the assembly efficiency of the core assembly 1.

In some embodiments, a separation wall 1012 is provided within the housing 10 for separating the accommodation cavity 1001 and the accommodation cavity 1002. In some embodiments, the separation wall 1012 is provided on the first housing 101 and/or the second housing 102, and the first housing 101 and the second housing 102 cooperate with each other to form the accommodation cavity 1001. The first housing 101 and/or the second housing 102 further form a portion of the accommodation cavity 1002. The third housing 103 cooperates with the first housing 101 and/or the second housing 102 to form another portion of the accommodation cavity 1002. The provision of the separation wall 1012 on the first housing 101 and/or the second housing 102 may be understood as that the separation wall 1012 belongs to a portion of the first housing 101 and/or the second housing 102. The first housing 101 and/or the second housing 102 further form a portion of the accommodation cavity 1002, and the third housing 103 cooperates with the first housing 101 and/or the second housing 102 to form the accommodation cavity 1002 of another portion of the accommodation cavity 1002. Of course, the manner in which the separation wall 1012 is provided is not limited to being provided on the first housing 101 and/or the second housing 102, and in other embodiments, the separation wall 1012 is provided as a separate portion of the first housing 101 and/or the second housing 102. In some embodiments, the separation wall 1012 is disposed on the first housing 101, and the first housing 101 is provided with a sub-accommodation cavity 1010 and a sub-accommodation cavity 1011 disposed on opposite sides of the separation wall 1012. An opening direction of the sub-accommodation cavity 1010 is provided along a wall surface of the separation wall 1012, and an opening direction of the sub-accommodation cavity 1011 is arranged to intersect with the wall surface of the separation wall 1012. The second housing 102 is provided with a sub-accommodation cavity 1020. The second housing 102 is covered on an opening end of the sub-accommodation cavity 1010, and the sub-accommodation cavity 1020 cooperates with the sub-accommodation cavity 1010 to form the accommodation cavity 1001. The third housing 103 is disposed with a sub-accommodation cavity 1030. The third housing 103 is covered on an opening end of the sub-accommodation cavity 1011, and the sub-accommodation cavity 1030 cooperates with the sub-accommodation cavity 1011 to form the accommodation cavity 1002.

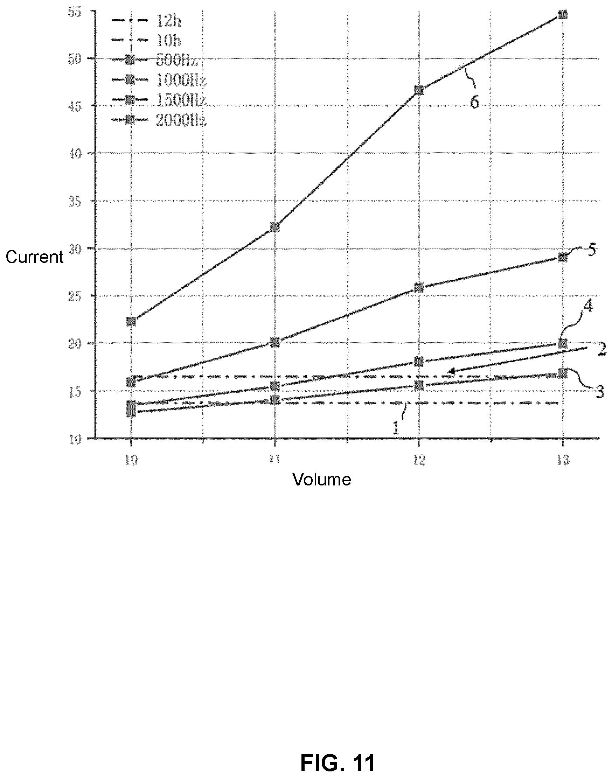

An acoustic output of the acoustic output device 100 includes the air conduction sound waves and the bone conduction sound waves. The acoustic output device 100 outputs the air conduction sound waves in the vicinity of the ear of the user, causing the user to hear the sound and also radiating the sound to surroundings, which causes a greater degree of sound leakage. In an application scenario of the acoustic output device 100, while an output volume of the acoustic output device 100 is enhanced to allow the user to hear a greater volume of sound, a volume of sound radiated to the surroundings is increased as well, resulting in a degree of sound leakage of the acoustic output device 100 to increase. Meanwhile, to enhance the output volume of the acoustic output device 100, vibration amplitudes of the bone conduction vibrator 11 and the air conduction vibrator 12 have to be increased accordingly, resulting in an increase in power consumption of the acoustic output device 100. The bone conduction vibrator 11 pushes a solid load (e.g., the second housing 102, user tissues, bones, etc.) to produce the bone conduction sound, and the air conduction vibrator 12 pushes an air load to produce the air conduction sound. In a range of a lower frequency band, the bone conduction vibrator 11 produces a sound to push a greater load compared to the air conduction vibrator 12, and the air conduction vibrator 12 consumes less power compared to the bone conduction vibrator 11 under a condition of enhancing the same output volume. Therefore, to enhance the output volume of the acoustic output device 100 while lowering the power consumption, the air conduction vibrator 12 may be allowed to output more low-frequency sound, while the bone conduction vibrator 11 may be allowed to output sound in a frequency range that is less likely to cover, or is farther from, the low-frequency range. For example, the air conduction sound waves are used instead of the bone conduction sound waves to be output in the lower frequency band (e.g., 20 Hz-1000 Hz) to reduce the power consumption of the acoustic output device 100. However, if the acoustic output device 100 simultaneously outputs the air conduction sound waves in a higher frequency band (e.g., 1000 Hz-5000 Hz), at this time, the sound leakage of the acoustic output device 100 in a far-field increases (e.g., in the high frequency band, a directivity of the air conduction sound waves output by the acoustic output device 100 in the far-field become poorer, and an ability to reduce the sound leakage becomes worse as described later), thereby affecting an overall sound quality of the sound emitted by the acoustic output device 100. As a result, the bone conduction sound waves may be output instead of the air conduction sound waves in the relatively high frequency band to enhance the overall sound quality of the sound emitted by the acoustic output device 100. In this way, the power consumption of the acoustic output device 100 may be significantly reduced, and the power consumption of the acoustic output device 100 may be maintained at a good level even when an output volume of the acoustic output device 100 is great (for details, referring to FIG. 11 and the descriptions thereof), and by adjusting a frequency range of the air conduction sound waves, the sound quality of the acoustic output device 100 may be adjusted to satisfy requirements of the user.

In some embodiments, to adjust the frequency ranges of the bone conduction sound waves and the air conduction sound waves, the acoustic output device 100 further includes a processing module (not shown). The processing module is used to provide a first audio signal and a second audio signal for the bone conduction vibrator 11 and the air conduction vibrator 12, respectively. Specifically, the acoustic output device 100 converts a raw audio signal, i.e., an electrical signal containing acoustic information, into a sound wave output that can be received by the user. The processing module performs a signal processing on the raw audio signal to obtain the first audio signal and the second audio signal. The bone conduction vibrator 11 vibrates in response to the first audio signal to generate the bone conduction sound waves, and the air conduction vibrator 12 vibrates in response to the second audio signal to generate the air conduction sound waves. The signal processing described herein may include, but is not limited to, at least one of a signal amplification, a phase adjustment, a filtering processing, etc. In some embodiments, the processing module processes the raw audio signal through hardware, software (an algorithm), or a combination thereof. For example, the processing module amplifies a signal through an amplification circuitry and/or an algorithm. In some embodiments, the hardware includes, but is not limited to, an equalizer (EQ), a dynamic range controller (DRC), a phase processor (GAIN), etc. In some embodiments, the processing module is disposed inside at least one of the two core assemblies 1 and the two earhook assemblies 2.

In some embodiments, the first audio signal and the second audio signal have a frequency division point. In the present disclosure, the frequency division point refers to an intersection point in the frequency domain of the first audio signal and the second audio signal that are processed by the processing module and output to the bone conduction vibrator 11 and the air conduction vibrator 12, respectively. The first audio signal includes a first frequency band (e.g., 500Hz-5kHz) including frequency components with frequencies above the frequency division point, and the second audio signal includes a second frequency band (e.g., 20Hz-500Hz) including frequency components with frequencies below the frequency division point.

It should be known that in the present disclosure, the frequency division point may be measured in the following manner: accessing a lead connected in parallel with an input end of the bone conduction vibrator 11 and an input end of the air conduction vibrator 12 from an output end of the processing module, and utilizing a sound card and Audition software, two groups of electrical signals are recorded and converted to the frequency domain. The two groups of electrical signals are converted to the frequency domain, and an intersection between curves of the two groups of electrical signals in the frequency domain is the frequency division point of the two groups of electrical signals.

In some embodiments, based on the frequency division point, the processing module determines components of a raw audio signal with frequencies within a first frequency band, i.e., the first audio signal, and components of the raw audio signal with frequencies within a second frequency band, i.e., the second audio signal. The bone conduction vibrator 11 vibrates in response to the first audio signal to generate the bone conduction sound waves within the first frequency band, and the air conduction vibrator 12 vibrates in response to the second audio signal to generate the air conduction sound waves within the second frequency band.

In the present disclosure, by outputting the sound of a lower frequency band (e.g., the second frequency band) in a form of the air conduction sound waves, the power consumption of the acoustic output device 100 is reduced, and the sound leakage with a frequency in the lower frequency band (e.g., the second frequency band) is not easily received by a human ear, which has less impact on a listening and a listening privacy of the user. Whereas by outputting the sound in a higher frequency band (e.g., the first frequency band) in a form of the bone conduction sound waves, the sound is transmitted through the tissues/the bones of the user, which enhances the sound quality of the sound output by the acoustic output device 100.

In some embodiments, the processing module processes the raw audio signal by high-pass filtering the raw audio signal to obtain the first audio signal, and low-pass filtering the raw audio signal to obtain the second audio signal. In some embodiments, the processing module includes a high-pass filter and a low-pass filter. The processing module performs the high-pass filtering and the low-pass filtering on the raw audio signal through the high-pass filter and the low-pass filter.

In some embodiments, a cutoff frequency of the low-pass filter is the same as a cutoff frequency of the high-pass filter. After the raw audio signal is processed by low-pass filtering, a portion of the raw audio signal greater than the cutoff frequency, i.e., the frequency division point, is filtered out, so as to mainly retain the low-frequency component below the cutoff frequency (i.e. the second audio signal). Similarly, after the raw audio signal is processed by high-pass filtering, a portion of the raw audio signal smaller than the cutoff frequency, i.e., the frequency division point, is filtered out, so as to mainly retain the high-frequency component above the cutoff frequency (i.e. the first audio signal). In some embodiments, the cutoff frequency of the low-pass filter is different from the cutoff frequency of the high-pass filter, at which point the frequency division point is the intersection of the first audio signal and the second audio signal output to the bone conduction vibrator and the air conduction vibrator in the frequency domain.

In some embodiments, the raw audio signal is a specific audio signal. The specific audio signal includes, for example, an audio signal stored internally in the acoustic output device 100 or in a device communicatively connected to an external world. For example, the internally stored audio signal of the acoustic output device 100 includes a white noise signal, a pure tone signal, a pulse signal, a narrowband noise, a narrowband warble tone, a modulated tone, and/or a swept tone signal.

In some embodiments, to make the acoustic output of the acoustic output device 100 more in the form of the air conduction sound waves to further reduce the power consumption, while ensuring a lower sound leakage in a more sensitive frequency range of the human ear, the frequency division point is no less than 600 Hz. For example, the frequency division point is 600 Hz, 800 Hz, 1 kHz, 1.2 kHz, 1.5 kHz, 2 kHz, 2.5 kHz, 3 kHz, 3.5 kHz, 4kHz, etc.

In some embodiments of the present disclosure, by disposing the frequency division point at a higher frequency, the acoustic output of the acoustic output device 100 is more in the form of the air conduction sound waves, and as the air conduction vibrator 12 pushes a smaller air load, the power consumption is effectively reduced, thereby ensuring that the acoustic output device 100 has a longer service life even at a higher volume.

In some embodiments, to further reduce the power consumption of the acoustic output device 100, a higher frequency division point is set so that the acoustic output of the acoustic output device 100 is more in the form of the air conduction sound waves. In some embodiments, the frequency division point is not less than 1 kHz. In some embodiments, the frequency division point is not lower than 1.5 kHz.

In some embodiments of the present disclosure, the acoustic output of the acoustic output device 100 is further reduced by setting a higher frequency division point so that the acoustic output of the acoustic output device 100 is more in the form of the air conduction sound waves (see, in particular, FIG. 11 and the descriptions thereof).

In some embodiments, the frequency division point with a higher frequency is set for a greater reduction in the power consumption of the acoustic output device 100, for example, the frequency division point is not less than 2 kHz, but then the human ear is relatively sensitive to the sound with the frequency lower than the frequency division point, and the higher frequency of the frequency division point, the worse the directivity of the air conduction sound in the far-field, resulting in an increase in the sound leakage of the acoustic output device 100, which affects the listening as well as the listening privacy of the user.

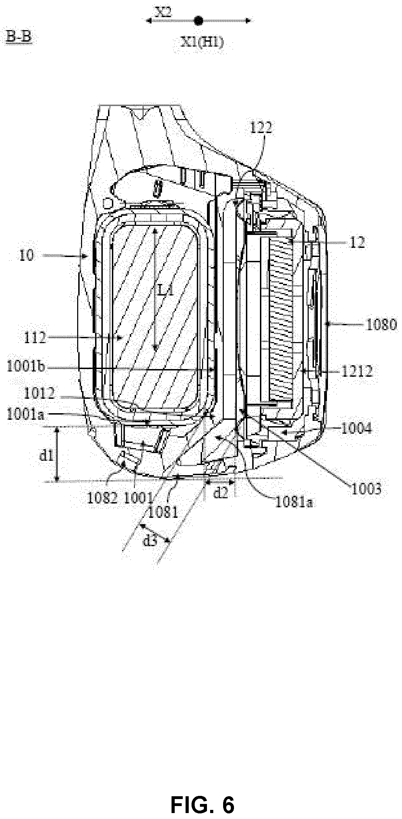

Accordingly, in some embodiments, to reduce the sound leakage from the acoustic output device 100, the housing 10 (e.g., the first housing 101, the second housing 102, and/or the third housing 103) of the acoustic output device 100 includes two sound guiding holes, e.g., the first sound guiding hole 1080 and the second sound guiding hole 1081, respectively, as illustrated in FIG. 6. The first sound guiding hole 1080 is used to guide the output of the air conduction sound waves generated by the air conduction vibrator 12, and the second sound guiding hole 1081 is used to relieve pressure for the air conduction vibrator 12 to ensure a normal and stable operation of the air conduction vibrator 12. The air conduction vibrator 12 may radiate sound with a phase difference to the outside world through the two sound guiding holes. In some embodiments, the air conduction vibrator 12 radiates sounds of equal (or substantially equal) amplitude and opposite (or substantially opposite) phases (i.e., have a phase difference) to the external world through the two sound guiding holes. The first sound guiding hole 1080 and the second sound guiding hole 1081 may form an output structure of a dipole or a dipole-like, which forms a directional radiated sound field similar to an "8" shape. In a straight line direction where the line connecting the first sound guiding hole 1080 and the second sound guiding hole 1081 is located, the sound guiding holes radiate the greatest sound, and the other directions radiate significantly less sound. Accordingly, the sound radiated by the acoustic output device to the surroundings (i.e., the far-field sound leakage) may be reduced by providing at least two sound guiding holes in the acoustic output device to construct the dipole or the dipole-like.

In some embodiments, to enable the first sound guiding hole 1080 and the second sound guiding hole 1081 to form the dipole or the dipole-like to enhance a sound leakage reduction capability of the acoustic output device, an amplitude difference of the sounds radiated from the two sound guiding holes may be made to be less than 6 dB (e.g., the amplitude difference is 1 dB, 3 dB, 5 dB, etc.), and the phase difference of the sounds radiated through the two sound guiding holes may be made to be in a range of 150°-210°. In some embodiments, to make the dipole-like that is formed by the first sound guiding hole 1080 and the second sound guiding hole 1081 more standardized, the amplitude difference of the sounds emitted by the two sound guiding holes is less than 5 dB, and the phase difference of the sounds emitted by the two sound guiding holes is in a range of 160°-200°. In some embodiments, the amplitude difference of the sounds emitted by the two sound guiding holes is less than 3 dB, and the phase difference of the sounds emitted by the two sound guiding holes is in a range of 170°-190°. In some embodiments, the amplitude difference of the sounds emitted by the two sound guiding holes is less than 3 dB, and the phase difference of the sounds emitted by the two sound guiding holes is in a range of 175°-185°. In some embodiments, a near-field sound pressure level difference between the two sound guiding holes is made less than 6 dB to make the amplitude difference of the sounds radiated from the two sound guiding holes less than 6 dB. Understandably, the smaller the near-field sound pressure level difference, the more significant the sound waves with the same amplitude and opposite phases are canceled in the far-field, and the better the effect of reducing sound leakage.

In the present disclosure, the near-field sound pressure level difference refers to a difference between the sound pressure levels of the sounds radiated by the two sound guiding holes to near-field positions of the two sound guiding holes. In the present disclosure, the near-field position of the sound guiding hole refers to a position within 5 mm from the sound guiding hole. For ease of understanding, the near-field sound pressure level difference may be expressed as a difference of the sound pressure levels at the two sound guiding holes of the acoustic output device 100.

In some embodiments, the near-field sound pressure level is tested by respectively measuring the sound pressures of sounds (a first sound and a second sound, respectively) radiating from the two sound guiding holes at a particular frequency point (e.g., 1000 Hz) and then calculating (e.g., by taking a common logarithm of a ratio of a sound pressure to be measured to a reference sound pressure and multiplying by 20 to obtain the corresponding sound pressure level) to obtain a sound pressure level difference between the first sound and the second sound. In some embodiments, when testing the sound of one certain sound guiding hole, a baffle is used to separate the two sound guiding holes to avoid the interference on the test from the other one sound guiding hole. The sound pressure at the sound guiding hole is understood to be a sound pressure at a position proximate to the sound guiding hole. For example, a sound collection device is disposed to collect the sound at a distance of 4 mm from the sound guiding hole as the sound pressure at that sound guiding hole.

In some embodiments, when testing the sounds from the two sound guiding holes, the positions (i.e., collection positions) 4 cm from the two sound guiding holes, respectively, are in a pair of opposite directions of the acoustic output device 100, respectively (e.g., a position 4 cm from a first sound hole is in a direction of a second sound hole pointing toward the first sound hole, and a position 4 cm from the second sound hole is in a direction of the first sound hole pointing toward the second sound hole). The sound collection device is set to collect the sound pressure levels of the acoustic output device 100 at two collection positions respectively, and the difference between the two sound pressure levels is calculated, which is the near-field sound pressure level difference between the two sound guiding holes.

In some embodiments of the present disclosure, by controlling the near-field sound pressures of the sounds radiated at the two sound guiding holes to be similar, it is possible to ensure that the first sound and the second sound effectively interfere and cancel with each other in a specific direction in the far-field, thereby effectively reducing the sound leakage of the acoustic output device 100 in the far-field.

The near-field sound pressure level difference may be adjusted in a variety of ways. In some embodiments, the near-field sound pressure level difference is adjusted by adjusting an opening area ratio of the two sound guiding holes.

The opening area ratio refers to a ratio of an area S1 of one sound guiding hole to an area S2 of the other sound guiding hole, i.e., the opening area ratio is equal to S1/S2.

In some embodiments, the ratio of the opening areas of the two sound guiding holes (i.e., the opening area ratio) is 0.2, 0.5, 1, 1.5, 2, 2.5, etc. In some embodiments, the ratio of the opening areas of the two sound guiding holes is in a range of 0.5-2. By controlling the range of the opening area ratio of the two sound guiding holes to make the opening areas of the two sound guiding holes close to each other, the sound resistances of the two sound guiding holes may be close to each other, so that the near-field sound pressure level difference between the two sound guiding holes is reduced, which makes the cancellation of far-field sound leakage is more significant, and improves the effect of the reduction of the sound leakage in the far-field.

Further, a ratio range of the opening areas of the two sound guiding holes may be 0.8-1.25, 0.9-1.1, or 0.95-1.1. By further narrowing the ratio range of the opening areas of the two sound guiding holes, and reducing the near-field sound pressure level difference, the effect of reducing the sound leakage in the far-field may be further improved.

In some embodiments, the near-field sound pressure level difference is also adjusted by adjusting a difference in sound loads of the two sound guiding holes. The sound load refers to a ratio of a sound pressure value P1 after passing through the sound guiding hole to a sound pressure value P0 without passing through the sound guiding hole, i.e., the sound load is equal to P1/P0. It should be noted that for the sound load of a certain sound guiding hole, the greater the sound load (or, the more it converges to 1), the smaller the sound resistance of the sound guiding hole.

In some embodiments, the sound load is determined by calculating a ratio of P1 to P0 based on separate measurements of a sound pressure value (P1) of the sound guiding hole when the sound guiding hole is covered with a screen mesh and a sound pressure value (P0) of the sound guiding hole when the sound guiding hole is not covered with a screen mesh at a specific distance from the sound guiding hole. Specifically, when measuring the sound of the sound guiding hole, the sound collection device may be set at a distance of 4-5 mm from the sound guiding hole, and P1 and P0 may be collected respectively, and finally the sound load of the sound guiding hole may be obtained. It should be noted that a test signal of the sound load may be a single-frequency signal, and one or more frequency points may be selected, which includes, but is not limited to, 100 Hz, 200 Hz, 300 Hz, 500 Hz, 1000 Hz, 2000Hz, 5000Hz, and a resonant frequency of the acoustic output device 100, etc. The test signal may also be selected as a white noise, a pink noise, and a swept frequency signal. It should be noted that in some embodiments, the measured sound pressure level needs to be converted to the sound pressure value before calculation to obtain the sound load. Alternatively, the sound pressure levels measured before and after the sound guiding hole is covered with the screen mesh may differ, and the value of the sound load of the sound guiding hole may be inversely calculated by a logarithmic formula.

In some embodiments, the difference between the sound loads of the two sound guiding holes includes 0.1, 0.15, 0.2, etc. In some embodiments, the difference between the sound loads of the two sound guiding holes is less than 0.15. Understandably, the smaller the difference between the sound loads of the two sound guiding holes, the closer the sound resistance of the two sound guiding holes, and thus the smaller the near-field sound pressure level difference between the two sound guiding holes, and the more effective the reduction of the far-field sound leakage.

Further, the difference between the sound loads of the two sound guiding holes may be less than 0.1. By further narrowing a difference range of the sound loads of the two sound guiding holes, the near-field sound pressure level difference between the two sound guiding holes may be further reduced, thereby further improving the effect of reducing the far-field sound leakage. To reduce the power consumption of the acoustic output device 100, the frequency division point may be shifted toward a higher frequency. When the frequency division point is shifted toward the higher frequency, i.e., the air conduction sound waves output by the acoustic output device 100 contain more high-frequency components, at this time, the sound leakage in the far-field of the acoustic output device 100 is progressively increased. As a result, when the frequency division point moves toward the high frequency, the difference between the sound loads of the two sound guiding holes may be reduced to further improve the effect of reducing the sound leakage in the far-field to ensure an output performance of the acoustic output device 100.

In some embodiments, to reduce the power consumption of the acoustic output device 100, the frequency division point is set in a range of 600 Hz-1 kHz, at which time, to make the acoustic output device 100 have less sound leakage in the far-field, the difference between the sound loads of the two sound guiding holes is in a range of 0-0.12. In some embodiments, to further reduce the power consumption of the acoustic output device 100, the frequency division point is set in a range of 1 kHz-1.5 kHz, at which time, the difference between the sound loads of the two sound guiding holes is set in a range of 0-0.1, so that the sound leakage of the acoustic output device 100 (or the air conduction vibrator 12) in the far-field is smaller. In some embodiments, to further reduce the power consumption of the acoustic output device 100, the frequency division point is set in a range of 1.5 kHz-2.5 kHz, at which time, the difference between the sound loads of the two sound guiding holes is set in a range of 0-0.07, so that the sound leakage of the acoustic output device 100 (or the air conduction vibrator 12) in the far-field is smaller. In some embodiments, to reduce the power consumption of the acoustic output device 100, the frequency division point is set in a range of 2.5 kHz-4 kHz, at which time, to make the sound leakage of the acoustic output device 100 (or the ai conduction vibrator 12) in the far-field smaller, the difference between the sound loads of the two sound guiding holes is set in a range of 0-0.05.

In some embodiments, the near-field sound pressure level difference is further adjusted by adjusting the ratio of surface sound loads of the two sound guiding holes.

The surface sound load refers to a product of a ratio of a sound pressure P1 after passing through the sound guiding hole to a sound pressure P0 without passing through the sound guiding hole and an area S of the sound guiding hole, i.e., the surface sound load is equal to S×P1/P0.

In some embodiments, the ratio of the surface sound loads of the two sound guiding holes is 0.5, 1, 2.5, etc. In some embodiments, the ratio of the surface sound loads of the two sound guiding holes is in a range of 0.5-3.5. By adjusting the ratio of the surface sound loads of the two sound guiding holes so as to keep it in a suitable range, the sound resistences of the two sound guiding holes may be made closer, thereby reducing the near-field sound pressure level difference between the two sound guiding holes, and improving the effect of reducing the sound leakage in the far-field.

Furthermore, the ratio of the surface sound loads of the two sound guiding holes is in a range of 0.8-2. It is appreciated that by further narrowing the range of the ratio of the surface sound loads of the two sound guiding holes, the reduction of the far-field sound leakage may be made more effective. To reduce the power consumption of the acoustic output device 100, the frequency division point shifts toward a higher frequency. When the frequency division point shifts toward the higher frequency, i.e., the air conduction sound waves output by the acoustic output device 100 contain more high-frequency components, the sound leakage in the far-field of the acoustic output device 100 is progressively increased. As a result, when the frequency division point shifts toward the high frequency, the ratio of the surface sound loads of the two sound guiding holes is reduced, thereby further improving the effect of reducing the sound leakage in the far-field to ensure the output performance of the acoustic output device 100.

In some embodiments, to reduce the power consumption of the acoustic output device 100, the frequency division point is set in a range of 600 Hz-1 kHz, at which time, to make the acoustic output device 100 have less sound leakage in the far-field, the ratio of the surface sound loads of the two sound guiding holes is in a range of 0.5-3.5. In some embodiments, to further reduce the power consumption of the acoustic output device 100, the frequency division point is set in a range of 1 kHz-1.5 kHz, at which time, the ratio of the surface sound loads of the two sound guiding holes is in a range of 0.6-2.7, so that the sound leakage of the acoustic output device 100 (or the air conduction vibrator 12) in the far-field is smaller. In some embodiments, to further reduce the power consumption of the acoustic output device 100, the frequency division point is set in a range of 1.5 kHz-2.5 kHz, at which time, the ratio of the surface sound loads of the two sound guiding holes is in a range of 0.7-2, so that the sound leakage of the acoustic output device 100 (or the air conduction vibrator 12) in the far-field is smaller. In some embodiments, to reduce the power consumption of the acoustic output device 100, the frequency division point is set in a range of 2.5 kHz-4 kHz, at which time, the ratio of the surface sound loads of the two sound guiding holes is in a range of 0.9-1.2, so that the sound leakage of the acoustic output device 100 (or the air conduction vibrator 12) in the far-field is smaller.

In some embodiments of the present disclosure, adjustments are made by adjusting the difference range of the sound loads and/or the ratio of the surface sound loads of the two sound guiding holes to make the sound resistences of the two sound guiding holes closer, thereby reducing the near-field sound pressure level difference between the two sound guiding holes, and making the sound field of the constructed dipole or dipole-like more directional in the far-field, which improves the effect of reducing the sound leakage in the far-field.

In some embodiments, to further reduce the sound leakage of the acoustic output device 100 in the far-field, the first sound guiding hole 1080 and the second sound guiding hole 1081 are made to radiate sounds to the outside world with a phase difference and/or a magnitude difference, so as to further modulate the sound field of radiation of the dipole or the dipole-like. Specifically, a cancellation degree of the sounds output by the acoustic output device 100 in the far-field is changed by regulating the phase difference between the two sounds output by the acoustic output device 100 from the two sound guiding holes, and when the phase difference satisfies certain conditions, the acoustic output device 100 is maintained to output a loud volume in a certain direction (e.g., a direction pointing to the ear canal of the user), while suppressing the sound leakage output by the acoustic output device 100 to the opposite direction, so that the sounds radiated to the outside world by the first sound guiding hole 1080 and the second sound guiding hole 1081 exhibit a strong directivity in a radiation space. The strong directivity is expressed as the far-field sound pressure level difference of not less than 3 dB in at least one pair of opposite directions (e.g., the direction in which the ear canal is located and the opposite direction thereof) of the sounds radiated from the two sound guiding holes, which results in a higher volume in the direction in which the ear canal of the user is located, and a lower sound leakage in the direction opposite to the direction thereof as well as other directions, thus providing a better balance between the openness of the ear canal and the listening privacy.

The far-field sound pressure level difference refers to a difference in the sound pressure level of the sound radiated in the far-field by each of the two sound guiding holes. In the present disclosure, the far-field of the sound guiding hole refers to a position 10 cm away from the sound guiding hole. For ease of understanding, the far-field sound pressure level difference between the two sound guiding holes is expressed as a difference of sound pressure levels at the same or approximately the same distance (or symmetrical positions) from the two sound guiding holes in the direction of a line connecting the two sound guiding holes, respectively. The far-field sound pressure level difference is tested in a similar manner as the near-field sound pressure level difference, which is not repeated. Differently, when measuring the far-field sound pressure level, for example, when collecting sound from the first sound guiding hole 1080 (or the second sound guiding hole 1081), the sound collection device is set to collect the sound at a distance of 30 cm from the first sound guiding hole 1080 (or the second sound guiding hole 1081).

In some embodiments, the far-field sound pressure level difference between the two sound guiding holes is regulated by setting the amplitude difference and the phase difference of the sounds emitted from the two sound guiding holes.

It should be noted that the phase of the sound radiated from the sound guiding hole (including the first sound guiding hole 1080 and the second sound guiding hole 1081) described in the embodiments of the present disclosure may be a phase measured at a distance of 4 mm from the sound guiding hole (or a geometric center of the sound guiding hole) (e.g., at a distance of 4 mm in front of the sound guiding hole). In some embodiments, the phase difference is tested by measuring the phases of the sounds radiated from the two sound guiding holes (the first sound and the second sound, respectively) separately, and then the phase difference between the first sound and the second sound is obtained by calculation. When testing the sound of the first sound guiding hole 1080 (or the second sound guiding hole 1081), a baffle is used to separate the first sound guiding hole 1080 and the second sound guiding hole 1081 to prevent the second sound guiding hole 1081 (or the first sound guiding hole 1080) from interfering the test. Further, the sound collection device may be placed on the line connecting the first sound guiding hole 1080 and the second sound guiding hole 1081 and at a distance of 4 mm from the first sound guiding hole 1080 (or the second sound guiding hole 1081) to collect the first sound, so as to further avoid the second sound guiding hole 1081 (or the first sound guiding hole 1080) from interfering the test. For illustrative purposes only, the baffle may be sized by standard dimensions. For example, a length, a width, and a height dimensions of the baffle are 1650mm, 1350mm, and 30mm, respectively. It is further noted that when the count of the first sound guiding holes 1080 (or the second sound guiding holes 1081) is two or more, any one of them is selected for testing. For example, the first sound guiding hole 1080 and the second sound guiding hole 1081 located at a particular relative position (e.g., at a minimum or maximum relative distance) are selected, and the phases of the sounds emitted from them are tested separately, and the phase difference is calculated. In addition, the sound measurements in a specific frequency band (e.g., 1000Hz-8000Hz) do not need to be exhaustive, but may be achieved by setting multiple (e.g., 20-30) frequency sampling points with equal steps whose endpoints are endpoints of the specific frequency band, and measuring the sound at each of the samples individually.

In some embodiments of the present disclosure, by setting a higher frequency division point so that most of the acoustic output of the acoustic output device 100 is output by the air conduction vibrator 12 in the form of the air conduction sound waves, and the power consumption is greatly reduced. At the same time, by adopting the output structure of the dipoles (two sound guiding holes) to reduce the sound leakage thereof, under a premise of guaranteeing the low-power consumption of the acoustic output device 100, a strong ability to reduce the sound leakage at low and medium frequencies (e.g., 20Hz-2.5kHz) is achieved, and an overall sound leakage performance of the acoustic output device 100 is relatively low.

When the frequency division point is greater than a certain frequency, the air conduction sound waves in the vicinity of the frequency division point have a higher frequency component. In a relatively high frequency band, due to the effect of a feature associated with generating sound of a cavity corresponding to each of the two sound guiding holes (e.g., more different modes are generated in the relatively high frequency band), it is difficult to maintain the same amplitude of the sound output from the two sound guiding holes, and at the same time, it is difficult to maintain a stable phase difference of 180°, which results in a poorer directionality of the sound in the far-field, and a poorer sound leakage reduction capability. Therefore, in some embodiments, to ensure that the acoustic output device 100 has a sufficient sound leakage reduction capability, the frequency division point is not higher than 4 kHz. In some embodiments, to ensure that the acoustic output device 100 has a superior sound leakage reduction capability, the frequency division point is not higher than 3 kHz.

In some embodiments of the present disclosure, by limiting the frequency division point to be no higher than 4 kHz, the radiated far-field sound pressure level difference between the two sound guiding holes conforms to a requirement to ensure the directivity of the sound in the far-field so as to ensure that the acoustic output device 100 has a sufficient sound leakage reduction capability.

In some embodiments, referring to FIG. 3, a vibration direction of the bone conduction vibrator 11 intersects with a vibration direction of the air conduction vibrator 12. The first housing 101 and the second housing 102 cooperate with each other along the vibration direction of the bone conduction vibrator 11, and the third housing 103 cooperates with the first housing 101 and/or the second housing 102 in the vibration direction of the air conduction vibrator 12. Specifically, the vibration direction of the bone conduction vibrator 11 is disposed in a crosswise manner with the vibration direction of the air conduction vibrator 12. The vibration direction of the bone conduction vibrator 11 is hereinafter referred to as a first vibration direction X1, and the vibration direction of the air conduction vibrator 12 may be referred to as a second vibration direction X2. The first vibration direction X1 and the second vibration direction X2 are not parallel to each other, but are set in a crosswise way, for example, set perpendicularly or approximately perpendicularly to each other (e.g., 90°±10°). When the bone conduction vibrator 11 and the air conduction vibrator 12 are operating at the same time, the bone conduction vibrator 11 and the air conduction vibrator 12 are vibrating along the first vibration direction X1 and the second vibration direction X2 respectively. Due to the two vibration directions crossing each other, the effect of the vibration of the bone conduction vibrator 11 on the sound quality of the air conduction vibrator 12 due to the vibration of the two in the same direction may be effectively mitigated. Furthermore, the first housing 101 and the second housing 102 are assembled in conjunction with each other along the first vibration direction X1, and the third housing 103 is assembled in conjunction with the first housing 101 along the second vibration direction X2. For example, only the first housing 101 and the third housing 103 cooperate to form the accommodation cavity 1002, and the third housing 103 only cooperates with the first housing 101 along the second vibration direction X2. Similarly, in other embodiments of the housing 10, the third housing 103 cooperates in the housing involved in forming the accommodation cavity 1002 along the second vibration direction X2. In this manner, the assembly of the core assembly 1 is facilitated to enhance the assembly efficiency of the core assembly 1.

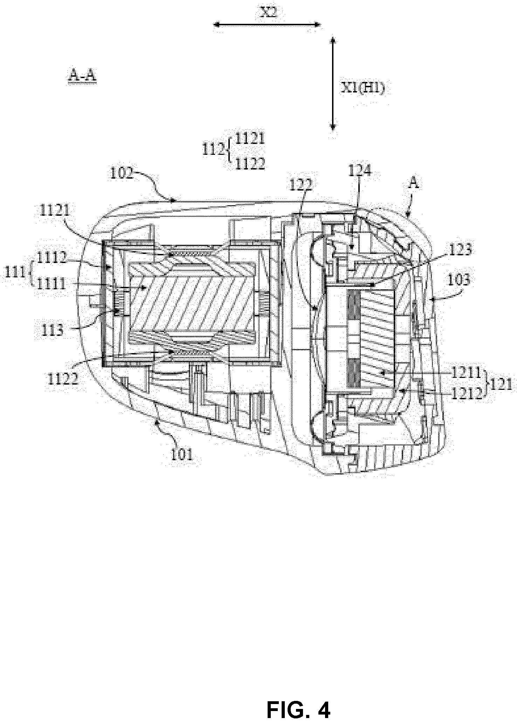

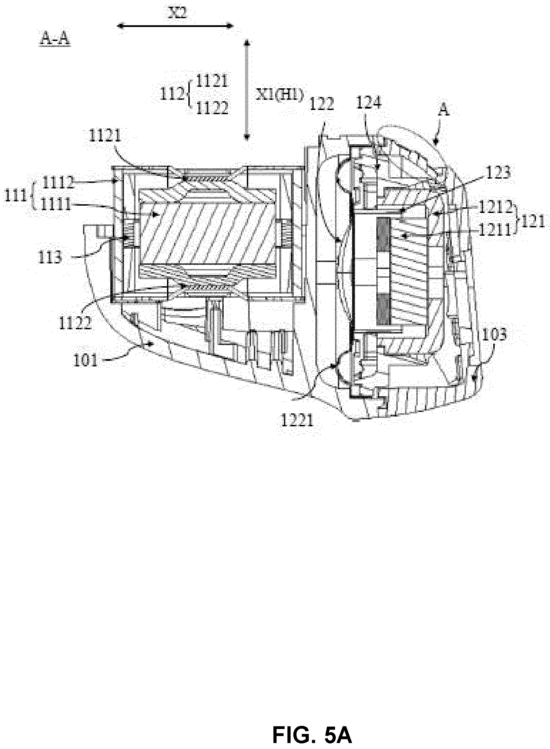

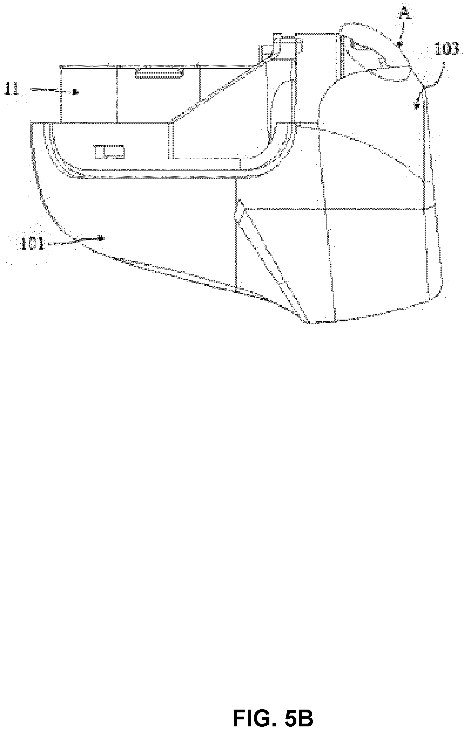

FIG. 4 is a schematic diagram illustrating a cross-section along a direction of an A-A section of a core assembly according to some embodiments of the present disclosure. FIG. 5A is a schematic diagram illustrating a cross-section along a direction of a section A-A of a core assembly according to some other embodiments of the present disclosure. FIG. 5B is a schematic diagram illustrating a structure of a core assembly according to some other embodiments of the present disclosure.

In some embodiments, as shown in FIG. 4, FIG. 5A, and FIG. 5B, the bone conduction vibrator 11 includes a first magnetic circuit 111, a vibration sheet 112, and a first coil 113. The first coil 113 extends into a magnetic gap of the first magnetic circuit 111 along the first vibration direction X1. The housing 10 is connected to a magnetic conduction shield 1112 of the first magnetic circuit 111. A magnetic field generated by the first coil 113 after it is powered and a magnetic field formed by the first magnetic circuit 111 interact to drive the vibration sheet 112 to generate a vibration along the first vibration direction X1, thereby making the magnetic conduction shield 1112 to vibrate under an action of a reaction force and transmit the vibration to the housing 10. The housing 10 transmits bone conduction sound waves through contacting the skin of the user.

In some embodiments, the first magnetic circuit 111 includes a magnet 1111 and the magnetic conduction shield 1112. For example, in the embodiment illustrated in FIG. 4, the magnetic conduction shield 1112 is a cylindrical structure, the magnetic conduction shield 1112 is socketed outside the first coil 113, the magnet 1111 is disposed inside the first coil 113, the magnetic conduction shield 1112 and the magnet 1111 are spaced apart in a direction perpendicular to the first vibration direction X1. An inner sidewall of the magnetic conduction shield 1112 and an outer side of the magnet 1111 form a magnetic gap of the first magnetic circuit 111, and the first coil 113 is disposed within the magnetic gap. In some embodiments, the magnetic conduction shield 1112 is connected to an inner wall of the housing 10 (e.g., the first housing 101 and/or the second housing 102, etc.) to achieve a fixation of the magnetic conduction shield 1112. In the embodiment illustrated in FIG. 4, two vibration transmission sheets 112 are respectively fixed to two ends of the cylindrical structure of the magnetic conduction shield 1112. In some embodiments, the two ends of the magnetic conduction shield 1112 are sealed, such that a space enclosed by the magnetic conduction shield 1112 forms a closed space, and a sound generated in the first magnetic circuit 111 does not leak out. In some embodiments, the first coil 113 is socketed around an axis parallel to the first vibration direction X1 of the bone conduction vibrator 11 on the outer side of the magnet 1111. In some embodiments, the magnetic conduction shield 1112 is socketed around an axis parallel to the first vibration direction X1 of the bone conduction vibrator 11 on the outer side of the first coil 113, i.e., the magnetic conduction shield 1112 and the magnet 1111 are spaced apart in a direction perpendicular to the first vibration direction X1 of the bone conduction vibrator 11. Specifically, the first coil 113 is connected to the magnetic conduction shield 1112. In some embodiments of the present disclosure, the first coil 113 is fitted to an inner wall of the magnetic conduction shield 1112.

In some embodiments, the magnet 1111 is fixed by the vibration sheet 112. For example, the vibration sheet 112 and the first magnetic circuit 111 are arranged along the first vibration direction X1, and a side of the vibration sheet 112 perpendicular to the first vibration direction X1 is connected to the side of the magnet 1111 perpendicular to the first vibration direction X1 to realize the fixation of the magnet 1111.

In some embodiments, the vibration sheet 112 includes a first vibration sheet 1121 and a second vibration sheet 1122, as shown in FIG. 4 and FIG. 5A. In the first vibration direction X1 of the bone conduction vibrator 11, the first vibration sheet 1121 and the second vibration sheet 1122 are connected to the magnet 1111 from the opposite sides of the magnet 1111, respectively. In some embodiments, the first vibration sheet 1121 and the second vibration sheet 1122 are disposed symmetrically on both sides of the first magnetic circuit 111. For example, the first vibration sheet 1121 and the second vibration sheet 1122 are symmetrically disposed on both sides of the first magnetic circuit 111 along the first vibration direction X1. In some embodiments, for ease of wearing, the symmetry axes of the first vibration sheet 1121 and the second vibration sheet 1122 and a center axis of the air conduction vibrator 12 are spaced apart in the first vibration direction X1 to increase a ventilation volume of the second sound guiding hole 1081 and/or an airflow channel 1081a.

In some other embodiments of the present disclosure, the bone conduction vibrator 11 includes only one vibration sheet 112. At this point, the magnetic conduction shield 1112 is a cylindrical structure with one end closed and one end open. The vibration sheet 112 may be disposed on one side of the opening of the magnetic conduction shield 1112. The magnet 1111 may be disposed within the magnetic conduction shield 1112. The first coil 113 may extend into the magnetic gap formed between the inner sidewall of the magnetic conduction shield 1112 and the outer side of the magnet 1111. The housing 10 is connected to the magnetic conduction shield 1112 by the vibration sheet 112, and the magnetic field generated by the first coil 113 after being powered interacts with the magnetic field formed by the first magnetic circuit 111 to drive the vibration sheet 112 to generate a vibration along the first vibration direction X1 and transmits the vibration to the housing 10 through the magnetic conduction shield 1112. The housing 10 transmits the bone conduction sound waves through contact with the skin of the user.

In some embodiments, the air conduction vibrator 12 includes a second magnetic circuit 121, a diaphragm 122, a second coil 123, and a pot support 124, as shown in FIG. 4, FIG. 5A, and FIG. 5B. The pot support 124 is used to provide a mounting platform. The second magnetic circuit 121, the diaphragm 122, and the second coil 123 are connected to the housing 10 through the pot support 124. The diaphragm 122 covers the second coil 123 and the second magnetic circuit 121 in the second vibration direction X2. The second coil 123 extends into a magnetic gap of the second magnetic circuit 121 and is connected to the diaphragm 122. A magnetic field generated by the second coil 123 when powered interacts with the magnetic field formed by the second magnetic circuit 121 to drive the diaphragm 122 to generate a mechanical vibration along the second vibration direction X2, and a sound is output through one or more sound guiding holes.

In some embodiments, the second magnetic circuit 121 includes a magnet 1211 and a magnetic conduction shield 1212. A side of the magnet 1211 away from the diaphragm 122 is mounted to a bottom wall of the magnetic conduction shield 1212. A magnetic gap is formed between a circumferential side of the magnet 1211 and a circumferential inner wall of the magnetic conduction shield 1212. In some embodiments, the circumferential outer wall of the magnetic conduction shield 1212 is connected and fixed to the pot support 124. In some embodiments, a folded ring 1221 is disposed on a circumferential side of the diaphragm 122, and the diaphragm 122 is connected and fixed to the pot support 124 through the folded ring 1221. In some embodiments, the pot support 124 is connected and fixed with the inner wall of the housing 10 (e.g., the second housing 102 and/or the third housing 103, etc.).

In some embodiments of the present disclosure, the vibration sheet 112 vibrates along the first vibration direction X1, the diaphragm 122 vibrates along the second vibration direction X2, the first vibration direction X1 intersects with the second vibration direction X2, and there is a certain angle therebetween. In this way, the vibration between the bone conduction vibrator and the air conduction vibrator may not affect each other, thereby ensuring the sounding efficiency of the bone conduction vibrator and the air conduction vibrator, and the accuracy of the sounding frequency. In some embodiments, to minimize the interaction between the vibrations of the bone conduction vibrator 11 and the air conduction vibrator 12 that affects an acoustic output performance of the acoustic output device 100, the angle between the first vibration direction X1 and the second vibration direction X2 is in a range of 80°-100°. In some embodiments, the angle between the first vibration direction X1 and the second vibration direction X2 is in a range of 85°-95°. In some embodiments, the angle between the first vibration direction X1 and the second vibration direction X2 is in a range of 88°-92°. In practice, to minimize the mutual influence of vibrations between the bone conduction vibrator 11 and the air conduction vibrator 12, the first vibration direction X1 is as perpendicular as possible to the second vibration direction X2, e.g., in the embodiment shown in the FIG. 4, the angle between the first vibration direction X1 and the second vibration direction X2 is 90°.

In some embodiments, the second magnetic circuit 121 of the air conduction vibrator 12 is disposed on a side of the diaphragm 122 away from the bone conduction vibrator 11. Specifically, the second coil 123, the pot support 124, and the second magnetic circuit 121 are located on the side of the diaphragm 122 away from the bone conduction vibrator 11.

In some embodiments of the present disclosure, as the diaphragm 122 covers the second coil 123 and the second magnetic circuit 121 in the second vibration direction X2, i.e., an area of the diaphragm 122 in the second vibration direction X2 is greater than an area of the second magnetic circuit 121 in the second vibration direction X2, at this time, by setting the second magnetic circuit 121 of the air conduction vibrator 12 on the side of the diaphragm 122 away from the bone conduction vibrator 11, it is convenient to set an A region of the housing 10 (refer to FIGs. 4, 5A, and 5B, where the A region is located at an articulation of the diaphragm 122 and the second magnetic circuit 121) into a chamfered structure, thereby making a structural distribution of the bone conduction vibrator 11 and the air conduction vibrator 12 inside the housing 10 more reasonable and compact. When the user wears the acoustic output device 100, the A region on the housing 10 is located at the user's tragus, and the A region formed into the chamfered adapts to a shape of the tragus, thereby avoiding the acoustic output device 100 from squeezing the tragus, and enhancing a wearing comfort of the user. In addition, by disposing the second magnetic circuit 121 of the air conduction vibrator 12 on the side of the diaphragm 122 away from the bone conduction vibrator 11, the low-frequency sound of the acoustic output device 100 is enhanced, and the acoustic output effect of the acoustic output device 100 is further enhanced.

In some embodiments, as shown in FIG. 4, FIG. 5A, and FIG. 5B, to ensure a pressure relief effect of the second sound guiding hole 1081, a mass center of the bone conduction vibrator 11 is disposed apart from a mass center of the air conduction vibrator 12 in the first vibration direction X1, in other words, the bone conduction vibrator 11 is set at a staggered position with the air conduction vibrator 12 in the first vibration direction X1 so as to increase a ventilation volume of the second sound guiding hole 1081 and/or the airflow channel 1081a. Additionally, due to the staggered setting of the bone conduction vibrator 11 and the air conduction vibrator 12 in the first vibration direction X1, it is further beneficial to make a structural distribution of the bone conduction vibrator 11 and the air conduction vibrator 12 inside the housing 10 more reasonable and compact, so that the acoustic output device 100 has a more beautiful appearance.

In some embodiments, the mass center of the bone conduction vibrator 11 and the mass center of the air conduction vibrator 12 are flush in the second vibration direction X2. To increase a ventilation volume of the second sound guiding hole 1081 and/or the airflow channel 1081a to increase the pressure relief effect of the second sound guiding hole 1081, the bone conduction vibrator 11 and the air conduction vibrator 12 may rotate relative to each other. At this time, the angle formed between a direction of a short axis of the bone conduction vibrator 11 (or the vibration sheet 112) and a vibration direction of the diaphragm 122 of the air conduction vibrator 12 is in a range of 0°-30°. In some embodiments, the angle formed between the direction of the short axis of the bone conduction vibrator 11 (or the vibration sheet 112) and the vibration direction of the diaphragm 122 of the air conduction vibrator 12 is in a range of 1°-20°. In some embodiments, the angle formed between the direction of the short axis of the bone conduction vibrator 11 (or the vibration sheet 112) and the vibration direction of the diaphragm 122 of the air conduction vibrator 12 is in a range of 2°-10°.

By rotating the bone conduction vibrator 11 and the air conduction vibrator 12 relative to each other, a distance from a center point of an angle formed between a first sidewall 1001a of the bone conduction vibrator 11 toward the second sound guiding hole 1081 and a second sidewall 1001b of the bone conduction vibrator 11 proximate to the diaphragm 122 to an apex of the folded ring 1221 of the diaphragm 122 of the air conduction vibrator 12 may be increased, so that a cross-sectional area of the airflow channel 1081a may be increased, thereby increasing the ventilation volume of the airflow in the airflow channel 1081a, so that a front cavity of the air conduction vibrator 12 has a better pressure relief effect, and the air conduction vibrator 12 has a better low-frequency effect.

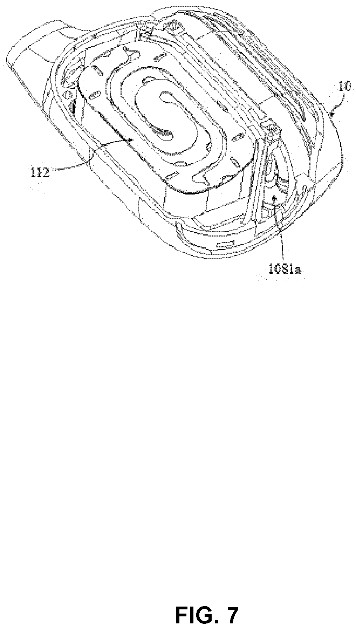

FIG. 6 is a schematic diagram illustrating a cross-section along a direction of a section B-B of a core assembly according to some embodiments of the present disclosure. FIG. 7 is a schematic diagram illustrating a cross-section of a second sound guiding hole according to some embodiments of the present disclosure.

In some embodiments, the air conduction vibrator 12 is disposed in the accommodation cavity 1002. The diaphragm 122 separates the accommodation cavity 1002 into a rear cavity 1004 and a front cavity 1003 disposed on opposite sides of the diaphragm 122. The rear cavity 1004 is disposed on a side of the diaphragm 122 away from the separation wall 1012, and the front cavity 1003 is disposed between the diaphragm 122 and the separation wall 1012. The first sound guiding hole 1080 connects the rear cavity 1004 to an external environment, and the second sound guiding hole 1081 connects the front cavity 1003 to the external environment. While the diaphragm 122 is vibrating in the air conduction vibration direction X2, the front cavity 1003 performs a pressure relief through the second sound guiding hole 1081.

In some embodiments, the first sound guiding hole 1080 is disposed on a portion of the housing 10 forming the rear cavity 1004. In some embodiments, the second magnetic circuit 121 is disposed in the rear cavity 1004, and the first sound guiding hole 1080 is disposed in a sidewall of the housing 10 that is fronted by a bottom wall of the magnetic conduction shield 1212 (or the second magnetic circuit 121). In this way, when the user wears the acoustic output device 100, the first sound guiding hole 1080 is made to face an ear canal of a user, so that air conduction sound waves output from the air conduction vibrator 12 are better transmitted into the ear canal of the user.

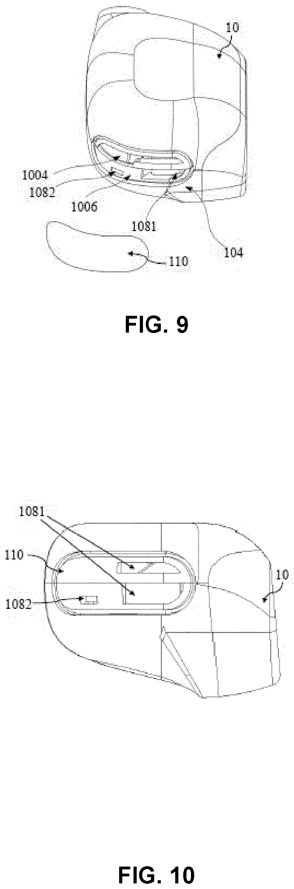

In some embodiments, to avoid or minimize the mutual influence between sounds output from the second sound guiding hole 1081 and the first sound guiding hole 1080 in the near-field, on a premise of ensuring that the second sound guiding hole 1081 is connected to the front cavity 1003, the second sound guiding hole 1081 is provided at a position as far away from the first sound guiding hole 1080 as possible. In some embodiments, the second sound guiding hole 1081 is provided on a sidewall (which is also referred to as a lower sidewall, such as the lower sidewall 104 shown in FIG. 9) of the housing 10 away from the earhook assembly 2 along an extension direction of the earhook assembly 2. In some embodiments, the second sound guiding hole 1081 is disposed on a portion of the housing 10 that forms the front cavity 1003 and is proximate the separation wall 1012. When the user wears the acoustic output device 100, the second sound guiding hole 1081 is located away from the earhook assembly 2 and near an earlobe of the user, which keeps the second sound guiding hole 1081 away from the ear canal of the user, avoids or minimizes an impact of the sound output from the second sound guiding hole 1081 on a hearing sound of the user.

In some embodiments, at least a portion of the separation wall 1012 extends toward a side where the accommodation cavity 1001 is located and forms a portion of a hole wall of the second sound guiding hole 1081. The airflow channel 1081a of the second sound guiding hole 1081 is set to extend toward the side where the accommodation cavity 1001 is located. In this way, the second sound guiding hole 1081 may be made to be further away from the first sound guiding hole 1080, which effectively minimizes the influence of the second sound guiding hole 1081 on the first sound guiding hole 1080, and improves a listening volume of the user. In addition, the airflow channel 1081a of the second sound guiding hole 1081 is set to extend toward the side where the accommodation cavity 1001 is located, so that a cross-section in a direction from an inlet end to an outlet end of the airflow channel 1081a gradually increases in size, so as to ensure an airflow volume of the second sound guiding hole 1081, and thus ensure a good pressure relief effect.

In the embodiment of the present disclosure, by setting the second sound guiding hole 1081 on a portion of the sidewall of the housing 10 away from the earhook assembly 2, the second sound guiding hole 1081 is set at a position as far away as possible from the first sound guiding hole 1080, thereby avoiding or preventing a sound output from the second sound guiding hole 1081 from affecting the listening of the user, and improving the listening volume.

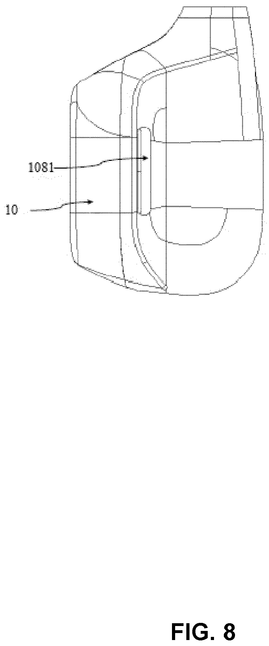

FIG. 8 is a schematic diagram illustrating a position where a second sound guiding hole is disposed according to some embodiments of the present disclosure.

In some embodiments, the second sound guiding hole 1081 is disposed on an outer sidewall of the housing 10, as shown in FIG. 8. The outer sidewall is a sidewall of the housing 10 away from the face of the user in a wearing state. As the first sound guiding hole 1080 is disposed on a sidewall of the housing 10 facing an ear canal of the user, the second sound guiding hole 1081 is disposed on the sidewall of the housing 10 away from the ear of the user. The second sound guiding hole 1081 is disposed away from the ear canal of the user, so that the sound output from the second sound guiding hole 1081 does not affect the hearing in the ear canal, and the hearing quality of the user is ensured.

In some embodiments, the acoustic output device 100 includes two or more second sound guiding holes in communication with the front cavity 1003. The plurality of second sound guiding holes are disposed on any sidewall of the housing 10. For example, the acoustic output device 100 includes two second sound guiding holes, and one of the second sound guiding holes is disposed on the outer sidewall, and the other second sound guiding hole is disposed on the lower sidewall. For another example, the acoustic output device 100 includes two second sound guiding holes, and both the two second sound guiding holes are disposed on the lower sidewall.

In some embodiments, the second sound guiding hole 1081 is connected to the front cavity 1003 through the airflow channel 1081a. In some embodiments, the vibration sheet 112 has a long axis direction L1 perpendicular to the first vibration direction X1 (see FIG. 6). In the present disclosure, a direction corresponding to the smallest size of the vibration sheet 112 is a short axis direction of the vibration sheet 112, and a direction perpendicular to the short axis direction is the long axis direction L1 of the vibration sheet 112. To make the acoustic output device 100 has sufficient space for the airflow channel 1081a, it is possible to make a distance d1 between a lowest point of the bone conduction vibrator 11 and a lowest point of an opening of the second sound guiding hole 1081 facing the outside of the acoustic output device in the long axis direction L1 not less than 1.00 mm, for example, 1.2 mm, 1.35 mm, 1.5 mm, 1.65 mm, 2 mm, etc. The lowest point referred to herein refers to a point furthest away from the earhook assembly 2 in the long-axis direction L1 in the wearing state.

In some embodiments of the present disclosure, by limiting the distance between the lowest point of the bone conduction vibrator 11 and the lowest point of the an opening of the second sound guiding hole 1081 facing the outside of the acoustic output device in the long axis direction L1, it is possible to allow the front cavity 1003 to have a sufficient space for the airflow channel 1081a and to avoid making the airflow channel 1081a of the second sound guiding hole 1081 too narrow to ensure that the front cavity 1003 has a sufficient pressure relief output to cancel with the sound of the first sound guiding hole 1080 in the far-field, thereby reducing the far-field sound leakage.

In some embodiments, to allow the front cavity 1003 to have sufficient space for the airflow channel 1081a, a curvature radius of a corner formed by the first sidewall 1001a of the bone conduction vibrator 11 close to the second sound guiding hole 1081 and a second sidewall 1001b close to the diaphragm 122 is greater than 1.00 mm. For example, the curvature radius is 1.2 mm, 1.5 mm, 1.8 mm, 2 mm, 2.5 mm, etc. In some embodiments, to allow the front cavity 1003 to have a sufficient space for providing the airflow channel 1081a, in the second vibration direction X2, a distance d2 from a center point of the corner formed by the first sidewall 1001a of the bone conduction vibrator 11 close to the second sound guiding hole 1081 and the second sidewall 1001b of the bone conduction vibrator 11 close to the diaphragm 122 to the apex of the folded ring 1221 of the diaphragm 122 is not less than 1.2 mm, for example, the distance d2 is 1.5 mm, 1.8 mm, 2 mm, 2.5 mm, 3 mm, etc.. The apex of the folded ring 1221 refers to a point on the folded ring 1221 that is closest to the bone conduction vibrator 11. In some embodiments, to allow sufficient space in the front cavity 1003 for the airflow channel 1081a, a distance d3 from the center point of the corner formed by the first sidewall 1001a of the bone conduction vibrator 11 close to the second sound guiding hole 1081 and the second sidewall 1001b of the bone conduction vibrator 11 close to the diaphragm 122 to the apex of the folded ring 1221 of the diaphragm 122 is not less than 1.5 mm, for example, the distance d3 is 1.8 mm, 2 mm, 2.4 mm, 2.6 mm, etc.

In some embodiments of the present disclosure, by limiting the curvature radius of the corner on the bone conduction vibrator 11 proximate to the second sound guiding hole 1081, and/or by limiting the distance from the center point of the corner on the bone conduction vibrator 11 proximate to the second sound guiding hole 1081 to the apex of the folded ring 1221 of the diaphragm 122, the front cavity 1003 has the sufficient space for the airflow channel 1081a to avoid making the airflow channel 1081a of the second sound guiding hole 1081 too narrow to ensure the sufficient relief output to cancel out the sound of the first sound guiding hole 1080.

In some embodiments, the cross-sectional area of the airflow channel 1081a of the second sound guiding hole 1081 progressively increases in a direction from the accommodation cavity 1002 to the external environment. In other words, the cross-sectional area of the airflow channel 1081a gradually increases in the direction from the accommodation cavity 1002 to the external environment while the airflow channel 1081a extends inclined toward the side of the accommodation cavity 1001, allowing for a smoother gas discharge, thereby enhancing the sound quality of the sound emitted by the acoustic output device 100. In some embodiments, to ensure that the second sound guiding hole 1081 has sufficient pressure relief output to cancel the sound from the first sound guiding hole 1080 in the far-field, a minimum cross-sectional area of the airflow channel 1081a of the second sound guiding hole 1081 is not less than 5.3 mm². In some embodiments, to further ensure that the second sound guiding hole 1081 has sufficient pressure relief output to cancel the sound from the first sound guiding hole 1080 in the far-field, the minimum cross-sectional area of the airflow channel 1081a of the second sound guiding hole 1081 is not less than 6 mm². For example, the minimum cross-sectional area is 6.2 mm², 6.5 mm², 6.8 mm², etc.

In some embodiments of the present disclosure, by limiting the minimum cross-sectional area of the airflow channel 1081a, the sufficient sound output from the second sound guiding hole 1081 is provided to cancel the sound from the first sound guiding hole 1080 to ensure a sufficient sound leakage reduction.

FIG. 9 is a schematic diagram illustrating a surface of a portion of a housing according to some embodiments of the present disclosure. FIG. 10 is a schematic diagram illustrating a surface of a portion of a housing according to some embodiments of the present disclosure.

In some embodiments, the acoustic output device 100 further includes a microphone that converts a sound signal (sound waves) into an audio signal, and the acoustic output device 100 is disposed with a microphone hole 1082 in the housing 10 of the acoustic output device 100 (e.g., the first housing 101, the second housing 102, and/or the third housing 103). The microphone picks up an external sound through the microphone hole 1082.

In some embodiments, the microphone hole 1082 and the second sound guiding hole 1081 are provided adjacent to each other, and the microphone hole 1082 and the second sound guiding hole 1081 are covered by the same steel mesh 110. In this way, an overall dimensional area of the steel mesh 110 is effectively enhanced, a risk of sweat, rain, and other undesirable external factors from infiltrating at the steel mesh 110 and forming a film of water that blocks the second sound guiding hole 1081 is reduced, and in turn, it is effectively ensured that the second sound guiding hole 1081 normally performs a pressure relief work, thereby effectively enhancing a stability of the sound emitted by the acoustic output device 100. In addition, the microphone hole 1082 and the second sound guiding hole 1081 are covered by the same steel mesh 110, which also makes the acoustic output device 100 have a better appearance. Further, as shown in FIG. 9, the steel mesh 110 is set in a curved arc shape, so that when the user wears the acoustic output device 100, the sweat, the rain, etc., flowing through the steel mesh 110 ultimately drips directly or slides down to a bottom of the steel mesh 110 (at a position of the second sound guiding hole 1081) before dripping down, thereby effectively preventing an accumulation of the sweat, the rain, and other undesirable external factors on the steel mesh 110 to form a blockage. In addition, by setting the steel mesh 110 into the curved arc shape, a kinetic energy of the sweat, the rain, and the other undesirable external factors is effectively increased, thereby effectively preventing the sweat, the rain, and the other undesirable external factors from accumulating on the steel mesh 110 blocking the second sound guiding hole 1081, and thereby effectively improving a working stability of the acoustic output device 100.

In some embodiments, the housing 10 is provided with a first recessed portion 1004. The first recessed portion 1004 is in communication with the second sound guiding hole 1081 and the airflow channel 1081a. The steel mesh 110 also covers an opening of the first recessed portion 1004. Based on this, when the liquid blocks a portion of the steel mesh 110, as the first recessed portion 1004 is connected to the airflow channel 1081a, a sound of the front cavity 1003 may be directed outwardly through the airflow channel 1081a from the first recessed portion 1004. That is, the first recessed portion 1004 may be used as an auxiliary pressure relief hole for the air conduction vibrator 12, which effectively increases a pressure relief area of the second sound guiding hole 1081, and when the second sound guiding hole 1081 is blocked, the air conduction vibrator 12 may continue to relieve the pressure through the first recessed portion 1004, so as to ensure a sound leakage reduction capability of the acoustic output device 100, and to effectively reduce a loss probability and a loss degree of a low-frequency sound of the acoustic output device 100, thereby effectively improving the working stability of the acoustic output device 100.

In some embodiments, the first recessed portion 1004, the microphone hole 1082, and the second sound guiding hole 1081 are completely covered by the steel mesh 110, which effectively prevents the external factors such as the sweat and the rain from blocking the second sound guiding hole 1081 and the first recessed portion 1004, and effectively prevents other external particulate undesirable factors from entering the front cavity 1003 along the second sound guiding hole 1081 and the first recessed portion 1004 and causes damage to the air conduction vibrator 12, thereby effectively enhancing the stability of the sound emitted by the acoustic output device 100. The steel mesh 110 is disposed in the curved arc shape based on the above-described manner, so that the sweat, the rain, and the other undesirable external factors flowing through the steel mesh 110 ultimately drip directly or slide to the bottom of the steel mesh 110 and then drips down, thereby effectively preventing the sweat, the rain, and the other undesirable external factors from accumulating at the steel mesh 110 and forming a crystal. Further, by setting the steel mesh 110 into the curved arc shape, a kinetic energy of the sweat, the rain, and the other undesirable external factors is enhanced, thereby effectively preventing the sweat, the rain, and the other undesirable external factors from accumulating at the steel mesh 110 and blocking the second sound guiding hole 1081, etc., thereby effectively enhancing the working stability of the acoustic output device 100.

In some embodiments, a position of at least a portion of the microphone hole 1082 is located closer to the earhook assembly 2 with respect to the second sound guiding hole 1081. When the sweat, the rain, and the other liquids flow down from a surface of the housing 10 to the bottom of the steel mesh 110 (or the bottom of the housing 10), the position of at least a portion of the microphone hole 1082 may be located closer to the earhook assembly 2 relative to the second sound guiding hole 1081, i.e., when the acoustic output device 100 is in a wearing state, the microphone hole 1082 is not at the bottom, thus the steel mesh 110 extended to the microphone hole 1082 is not easily blocked, and the gas in the airflow channel 1081a may be transmitted to the steel mesh extending to the position of the microphone hole 1082 via the second sound guiding hole 1081 and output outward, thereby ensuring a normal operation of the air conduction vibrator 12.

In some embodiments of the present disclosure, by enlarging the area of the steel mesh 110 or by making the outer surface of the steel mesh 110 form a cavity with the outer surface of the housing 10, it is possible to prevent the steel mesh 110 from being completely blocked by the liquid to ensure that the sound of the second sound guiding hole 1081 is output smoothly, thereby ensuring the sound leakage reduction capability of the acoustic output device 100.

FIG. 11 is a diagram illustrating an effect of a frequency division point on a power consumption of an acoustic output device according to some embodiments of the present disclosure. In FIG. 11, a horizontal coordinate represents an output volume level of the acoustic output device 100 (the value indicates frames of the volume), and a vertical coordinate represents a power consumption current of the acoustic output device 100. The higher the current, the higher the power consumption. Curve 1 represents the power consumption at a standard volume when a target product has a battery life of 10h, and curve 2 represents the power consumption at the standard volume when the target product has a battery life of 12h. Curves 3, 4, 5, and 6 represent the power consumption currents of the acoustic output device 100 at frequency division points of 2kHz, 1.5kHz, 1kHz, and 500Hz, respectively. As can be seen in FIG. 11, the power consumption tends to increase as the output volume (count of volume frames) increases. At the same time, as the frequency division point increases, the power consumption at the same output volume decreases significantly. When the frequency division point is 2kHz, i.e., curve 3 is lower than curve 2 and closer to curve 1 at 11-12 frames of volume. Additionally, as the frequency division point increases, the power consumption current increases more slowly with the volume, it can be seen that increasing the frequency division point is also advantageous for reducing the power consumption in a loud volume situation.

Therefore, in some embodiments, the frequency division point is set to be not less than 1 kHz, 2 kHz, etc. At the same time, an output structure of dipoles (two sound guiding holes) is used to reduce a sound leakage of the acoustic output device 100, so that the acoustic output device 100 has a strong sound leakage reduction capability at low and medium frequencies (e.g., 20 Hz-2.5 kHz) while ensuring a low power consumption, and has a lower sound leakage performance in general.

The basic concepts have been described above, and it is apparent to those skilled in the art that the foregoing detailed disclosure serves only as an example and does not constitute a limitation of the present disclosure. While not expressly stated herein, those skilled in the art may make various modifications, improvements, and amendments to the present disclosure. Those types of modifications, improvements, and amendments are suggested in the present disclosure, so those types of modifications, improvements, and amendments remain within the spirit and scope of the exemplary embodiments of the present disclosure.

## Claims

1. An acoustic output device, comprising:
a housing;
a bone conduction vibrator configured to generate bone conduction sound waves and transmit the bone conduction sound waves to a cochlea through the housing to produce sound;
an air conduction vibrator configured to generate air conduction sound waves, the air conduction sound waves being transmitted to an ear through sound guiding holes in the housing; and
a processing module configured to provide the bone conduction vibrator and the air conduction vibrator with a first audio signal and a second audio signal, respectively, the first audio signal and the second audio signal having a frequency division point, the first audio signal and the second audio signal including components with frequencies above and below the frequency division point, respectively, wherein the frequency division point is not less than 600 Hz.

2. The acoustic output device of claim 1, wherein the frequency division point is not less than 1500 Hz.

3. The acoustic output device of claim 1, wherein the housing includes two sound guiding holes, wherein sounds radiated through the two sound guiding holes to a far field show a directivity, the directivity being expressed as a difference between a sound pressure level in a direction of a line connecting the two sound guiding holes and a sound pressure level in at least one other direction being not less than 3 dB.

4. The acoustic output device of claim 3, wherein an amplitude difference between sounds emitted from the two sound guiding holes is less than 6 dB and a phase difference between the sounds emitted from the two sound guiding holes is 150°-210°.

5. **The** acoustic output device of claim 4, wherein a difference between sound loads of the two sound guiding holes is less than 0.15.

6. **The** acoustic output device of claim 4, wherein the frequency division point is not higher than 4000 Hz.

7. **The** acoustic output device of claim 1, wherein the processing module obtains the first audio signal and the second audio signal by performing a high-pass filtering process and a low-pass filtering process on an electrical signal containing sound information, respectively.

8. **The** acoustic output device of claim 1, wherein
the bone conduction vibrator includes a first magnetic circuit, a vibration sheet, and a first coil, and
the air conduction vibrator includes a diaphragm, a second magnetic circuit, and a second coil,
wherein an angle between a first vibration direction of the vibration sheet in the first magnetic circuit and a second vibration direction of the diaphragm in the second magnetic circuit is in a range of 80°-100°.

9. **The** acoustic output device of claim 8, wherein a mass center of the bone conduction vibrator is spaced apart from a mass center of the air conduction vibrator in the first vibration direction.

10. **The** acoustic output device of claim 8, wherein the bone conduction vibrator includes two vibration sheets symmetrically disposed on both sides of the first magnetic circuit, and a symmetry axis of the two vibration sheets is spaced apart from a center axis of the air conduction vibrator in the first vibration direction.

11. The acoustic output device of claim 8, wherein the second magnetic circuit of the air conduction vibrator is located on a side of the diaphragm away from the bone conduction vibrator.

12. The acoustic output device of claim 11, wherein the housing includes a first sound guiding hole and a second sound guiding hole, wherein the first sound guiding hole is located in a sidewall of the housing opposite to a bottom wall of the second magnetic circuit away from the diaphragm, and the second sound guiding hole is connected to a front cavity where a side of the diaphragm away from the second magnetic circuit is located.

13. The acoustic output device of claim 12, further including:
an earhook assembly connected to the housing, wherein the second sound guiding hole is disposed in a sidewall of the housing away from the earhook assembly in an extension direction of the earhook assembly.

14. The acoustic output device of claim 13, wherein the vibration sheet includes a long axis direction perpendicular to the first vibration direction, and in the long axis direction, a distance between a lowest point of the bone conduction vibrator and a lowest point of an opening of the second sound guiding hole facing the outside of the acoustic output device is not less than 1.0 mm.

15. The acoustic output device of claim 13, wherein a curvature radius of a corner formed by a first sidewall of the bone conduction vibrator close to the second sound guiding hole and a second sidewall of the bone conduction vibrator close to the diaphragm is greater than 1.0 mm.

16. The acoustic output device of claim 12, wherein the front cavity includes an airflow channel connected to the second sound guiding hole, and a minimum cross-sectional area of the airflow channel is not less than 5.3 mm².

17. The acoustic output device of claim 13, further including:
a microphone, wherein the housing is disposed with a microphone hole corresponding to the microphone, and the microphone hole and the second sound guiding hole are covered by a same steel mesh.

18. The acoustic output device of claim 17, wherein in a wearing state, the microphone hole is closer to the earhook assembly relative to the second sound guiding hole.
